# EUROPEAN PATENT APPLICATION

(11) **EP 4 765 638 A1**
(43) Date of publication of application: **24.06.2026**
(21) Application number: 24222126.5
(22) Date of filing: 20.12.2024
(51) Int. Cl.: H03K 5/1254

(54) **LOW-POWER DEBOUNCING LOGIC CIRCUIT WITH REDUCED UNCERTAINTY FOR INPUT PULSE PROPAGATION**

(71) Applicant: EM Microelectronic-Marin SA, 2074 Marin (CH)
(72) Inventor: HAJEK, Radek, 664 54 Nesvacilka (CZ); HRDY, Tomas, 252 19 Rudná (CZ); PRAZAN, Michal, 130 00 Praha (CZ)
(74) Representative: ICB SA

(57) **Abstract**

The present invention concerns a debouncing logic circuit for processing an asynchronous input signal (din) and provide a debounced signal (dout), comprising a clock edge (ck), a first stage of flip-flops (q0; q1) driven by the clock edge, a multiplexer (MUX1) and coupled to the first stage of flip-flops, a second stage of flip-flops (q2; q3), a counter logic module (cnt) driven by the clock edge, a comparator module, a second multiplexer (MUX2) operable to select between the processed output signal and the debounced signal based on the control signal from the comparator, the internal state being the selected signal and an output stage (q4) driven by the clock edge and configured to provide the debounced signal (dout).

## Description

### Field of the invention

The field of the invention relates to digital signal processing and electronic circuit design, specifically to debouncing logic circuits used for filtering glitches in asynchronous input signals, such as those generated by mechanical switches, in low-power and high-reliability applications.

### Background of the invention

In digital systems, mechanical switches are widely employed as input devices to generate input signals. However, these switches inherently produce transient, spurious signals, referred to as "bounces," which result from mechanical imperfections during state transitions. These bounces can cause to multiple unintended signal transitions, leading to errors or malfunctions in digital circuits. To mitigate this issue, debouncing circuits are employed to filter out these glitches and provide a stable output signal.

Traditional debouncing circuits often utilize a combination of flip-flops and clock signals to sample the input and determine the output state. A common low-power implementation involves a flip-flop with asynchronous set and reset functions, controlled by the input signal and the current internal state of the debouncer. This configuration relies on a feedback loop to ensure immediate evaluation of the next internal state. While effective in filtering out short glitches, this design introduces uncertainty in input pulse propagation. Specifically, input pulses shorter than one clock period are not propagated, those longer than two clock periods are propagated, and pulses within this range may or may not be propagated, leading to ambiguity in signal processing.

Existing debouncing circuits primarily rely on the clock period to establish the debouncing time, which inherently links the precision of pulse propagation to the clock cycle duration. Since typical debouncing times for mechanical switches range from several milliseconds, the corresponding clock period becomes significantly prolonged, amplifying the uncertainty in input pulse propagation and reducing the system's responsiveness to short pulse. This dependency restricts the flexibility of the circuit and may not meet the stringent timing requirements of certain applications.

Therefore, an objective of the present invention is to develop a debouncing logic circuit that maintains low-power consumption while significantly reducing the uncertainty in input pulse propagation.

### Summary of the invention

In one aspect the present invention relates to a a debouncing logic circuit for processing an asynchronous input signal and provide a debounced signal, comprising:
- a clock edge configured to provide timing signal;
- a first stage of flip-flops driven by the clock edge and configured to receive the input signal and produce output signals;
- a multiplexer and coupled to the first stage of flip-flops, operable to select an output signal from the output signals based on an internal state of the debouncing logic circuit;
- a second stage of flip-flops, configured to stabilize the selected output signal from the multiplexer and generate a processed output signal;
- a counter logic module driven by the clock edge and configured to increment a counter when a mismatch is detected between the processed output signal and the debounced signal, and reset the counter when a control signal is set to a logic high value;
- a comparator module, operable to evaluate the counter value against a programmable threshold and generate a control signal which is set to high logic when the counter value is equal to the programmable threshold;
- a second multiplexer operable to select between the processed output signal and the debounced signal based on the control signal from the comparator, the internal state being the selected signal;
- an output stage driven by the clock edge and configured to provide the debounced signal.

Advantageously, the debouncing logic circuit comprises a programmable register operable to define the threshold value for the comparator module, enabling user-defined adjustments of debouncing duration.

In particular, the second stage of flip-flops includes at least two sequential flip-flops configured to stabilize the output signal for downstream operations.

Typically, the second multiplexer selects the output of the second stage of flip-flops when the counter value meets or exceeds the threshold defined by the comparator module.

### Brief description of the drawings

The present invention will be described subsequently in more detail with reference to the attached drawing, given by way of examples, but in no way limited thereto, in which:
- Figure 1 illustrates an existing low-power debouncing logic, and
- Figure 2 illustrates a low-power debouncing logic according to an embodiment of the invention.

### Detailed description of the invention

The present invention relates to a debouncing circuit designed to process asynchronous input signals, eliminate noise, and provide a stable and reliable output signal. This type of circuit is particularly useful in digital systems where signals from mechanical switches or other unsynchronized sources may contain bounces or spurious pulses. These bounces, if not properly filtered, can cause errors in the operation of digital circuits. The present invention addresses these challenges by introducing synchronization mechanisms, programmable control, and improved precision in signal processing, all while maintaining minimal power consumption.

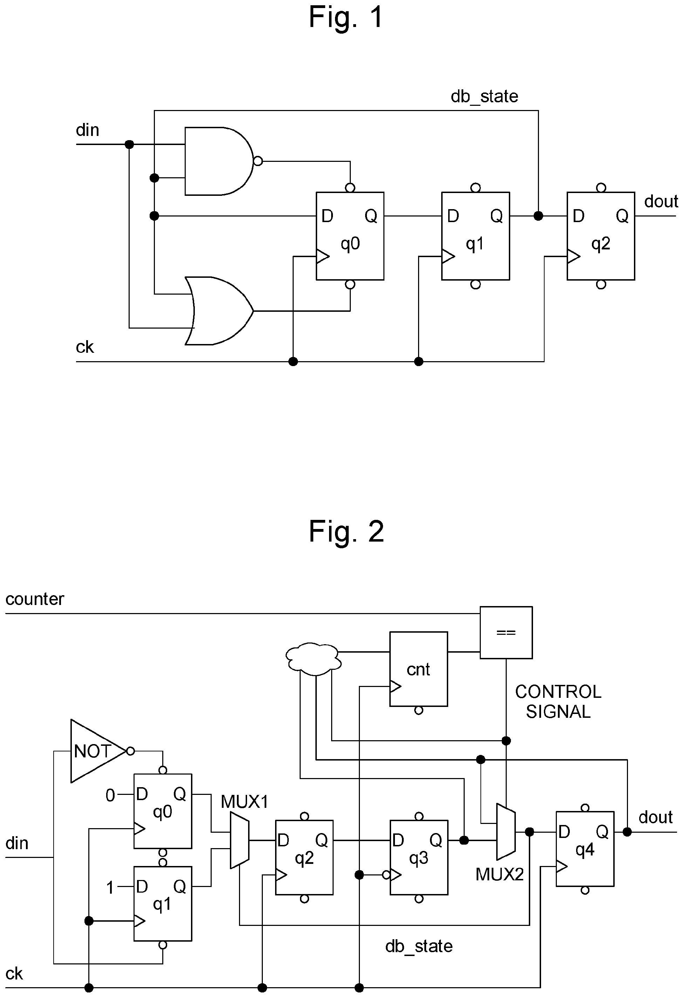

An existing debouncing circuit is illustrated in Figure 1. The debouncing circuit uses a small number of logic gates and operates with a low-frequency clock (ck).

A first flip-flop q0 samples the logic state of an input signal (din). It features asynchronous set (set) and reset (reset) inputs that depend on the state of the input signal (din) and a current internal state of the debouncing circuit (db_state), which is the output of a second flip-flop q1. The circuit's correct operation is ensured by a feedback loop that connects the output of flip-flop q1 back to its input D. This feedback mechanism ensures that any change in the internal state (db_state) immediately updates the evaluation of the next state.

When the output state of the internal state is logic high, any input signal (din) that is also logic high triggers an asynchronous set operation on flip-flop q0. If the input signal transitions to logic low and remains stable for at least two consecutive clock rising edges, the internal state of the debouncing circuit is updated to logic low. On the next rising edge of the clock, the stabilized output signal (dout) also transitions to logic low.

If the internal state of the debouncing circuit is logic low, the process repeats with reversed polarity. A logic low input signal asynchronously resets flip-flop q0. To switch the internal state and output signal to logic high, a logic high input signal must remain stable for at least two consecutive clock rising edges. This cyclical behavior is dictated by the current internal state and the input signal value.

This solution has a significant limitation: the debouncing time and the uncertainty in pulse propagation are directly tied to the clock (ck) period. Specifically, an input pulse shorter than one clock period is not propagated, while an input pulse longer than two clock periods is always propagated. Input pulses with a duration between one and two clock periods may or may not be propagated, depending on their timing relative to the clock signal.

The behavior of this conventional debouncing circuit is fundamentally constrained by its dependency on the clock period. The timing and precision of input pulse propagation are directly determined by the clock cycle duration. This results in an uncertainty window that spans exactly one clock period, preventing the system from reliably differentiating input signals within this range. Consequently, the circuit's response to fast-changing input signals can be inconsistent.

For example, input pulses shorter than one clock period are ignored entirely because the circuit lacks the temporal resolution to detect them. Input pulses lasting longer than two clock periods are always propagated, as they exceed the circuit's uncertainty threshold. However, the circuit cannot reliably handle pulses with durations between one and two clock periods, as their propagation depends on their precise alignment with the clock, leading to unpredictable behavior.

In practical applications, the dependency on the clock period restricts performance, as debouncing times in the millisecond range necessitate proportional clock cycles. This scaling increases the uncertainty window for pulse propagation, thereby limiting the circuit's ability to reliably process shorter or borderline input pulses. This tradeoff between debouncing time and uncertainty creates a significant constraint in applications where high precision and responsiveness are critical.

These limitations highlight the challenges faced by conventional debouncing circuits and emphasize the need for an improved design that can address these drawbacks while maintaining reliable and predictable behavior.

Figure 2 illustrate an embodiment of a sequential digital circuit composed of interconnected elements designed for state-based processing of an input signal.

The signal flow starts with the input din, which serves as the primary data source for the system and generates a dout signal.

This signal is din undergoes dual processing: it is inverted by a NOT gate to produce a complementary signal, which is supplied to set input S of a first flip-flop q0, and directly supplied to the reset input R (reset input) of a second flip-flop q1. The set part is set asynchronously by input data in logic 1, 0 gets propagated by rising edge of clock synchronously. The clear part is opposite - cleared asynchronously by input data low, logic 1 gets propagated synchronously.

Flip-flops q0 and q1 constitute the initial stage of data storage and signal processing, generating outputs representing both direct and inverted states of the input signal. These outputs form the inputs to a first multiplexer, MUX1, which performs signal selection.

Multiplexer MUX1 selects one of the outputs from flip-flops q0 and q1 based on an internal state db_state. If the internal state is at logic 0, the selected output is the one of the second flip-flop q1. If the internal state is at logic 1, the selected path is the one of the first flip-flop q0.

The selected output is routed to a third flip-flop q2, which serves as an intermediate storage stage for propagating the processed signal. The output of flip-flop q2 is subsequently routed to a fourth flip-flop q3, which further stabilizes or processes the signal for downstream operations.

Flip-flop q3 is sensitive to the opposite clock edge.

The output of the fourth flip-flop q3 is store on a state register output and is provided to a second multiplexer (MUX2). In parallel, MUX2 also receives the dout signal. Multiplexer MUX2 performs a selection operation to determine whether the output of flip-flop q3 or the alternative dout signal is propagated. The selected signal, which is the internal state, is then routed to a fifth flip-flop q4, which generates the final system output, denoted as dout. This output represents the fully processed and stabilized signal, designed to minimize glitches and unwanted fluctuations.

A counter logic module is integrated in parallel with the data path. The counter is incremented only when the state register output (from flip-flop q3) does not match the output state of the debouncing logic dout. Otherwise, the counter is reset to zero. The counter output is evaluated by a comparator block, which checks whether the counter value reaches a predetermined threshold. Upon satisfying this condition, the comparator generates a signal that is supplied to MUX2 as a selection signal. The control logic also resets the counter whenever the input signal aligns with the internal state, ensuring synchronization and preventing erroneous counting.

Accordingly, MUX2 selects the output of the fourth flip-flop q3 only when the state signal differs from the output of the debouncing logic dout and the counter value reaches the defined threshold.

The proposed solution minimizes pulse propagation uncertainty to a single clock period while allowing extended debouncing times through adjustable counter width and programmable threshold values. This design enables precise and flexible control of the debouncing duration to accommodate various application requirements:
- Input pulse < (counter + 1) clock period, pulse is not propagated,
- Input pulse > (counter + 2) clock period, pulse is propagated,
- Input pulse in range of <(counter + 1); (counter + 2)> clock periods, pulse may be propagated.

The described interconnections and functional relationships are designed to implement a robust and adaptable debouncing mechanism. The dynamic selection logic of the multiplexers, in conjunction with the state register and feedback loop, provides seamless integration. The counter and comparator enforce strict thresholds to filter transient signals, while a programmable limit register allows user-defined adjustment of the debouncing duration, enhancing flexibility for diverse application-specific requirements.

This debouncing logic circuit offers significant advantages for applications necessitating precise processing of asynchronous input signals, including microcontroller systems and noise-sensitive environments. Its programmable architecture provides user-defined flexibility, while its robust metastability resolution and efficient feedback mechanism ensure consistent and reliable operation, even in glitch-prone conditions. The invention provides an efficient debouncing solution with minimized uncertainty, reduced power consumption, and high adaptability to a wide range of electronic systems.

## Claims

1. A debouncing logic circuit for processing an asynchronous input signal (din) and provide a debounced signal (dout), comprising:
- a clock edge (ck) configured to provide timing signal;
- a first stage of flip-flops (q0; q1) driven by the clock edge and configured to receive the input signal and produce output signals;
- a multiplexer (MUX1) and coupled to the first stage of flip-flops, operable to select an output signal from the ouput signals based on an internal state (db_state) of the debouncing logic circuit;
- a second stage of flip-flops (q2; q3), configured to stabilize the selected output signal from the multiplexer and generate a processed output signal;
- a counter logic module (cnt) driven by the clock edge and configured to increment a counter when a mismatch is detected between the processed output signal and the debounced signal, and reset the counter when a control signal is set to a logic high value;
- a comparator module, operable to evaluate the counter value against a programmable threshold and generate a control signal which is set to high logic when the counter value is equal to the programmable threshold;
- a second multiplexer (MUX2) operable to select between the processed output signal and the debounced signal based on the control signal from the comparator, the internal state being the selected signal;
- an output stage (q4) driven by the clock edge and configured to provide the debounced signal (dout).

2. The debouncing logic circuit of claim 1, further comprising a programmable register operable to define the threshold value for the comparator module, enabling user-defined adjustments of debouncing duration.

3. The debouncing logic circuit of claim 1, wherein the second stage of flip-flops includes at least two sequential flip-flops configured to stabilize the output signal for downstream operations.

4. The debouncing logic circuit of claim 1, wherein the second multiplexer (MUX2) selects the output of the second stage of flip-flops when the counter value meets or exceeds the threshold defined by the comparator module.
